# EUROPEAN PATENT SPECIFICATION

(11) **EP 1 339 103 B1**
(45) Date of publication and mention of the grant of the patent: **12.09.2007**
(21) Application number: 02425088.8
(22) Date of filing: 20.02.2002
(51) Int. Cl.: H01L 23/522, H01L 23/528, H01L 45/00, H01L 27/24

(54) **Sublithographic contact structure, phase change memory cell with optimized heater shape, and manufacturing method thereof**
Sublithographische Kontaktstruktur, Phasenwechsel-Speicherzelle mit optimierter Heizstruktur sowie deren Herstellungsverfahren
Structure de contact sub-lithographique, cellule mémoire à changement de phase ayant un élément de chauffage avec forme optimisée et sa méthode de fabrication

(43) Date of publication of application: 27.08.2003
(73) Proprietor: STMicroelectronics S.r.l., 20041 Agrate Brianza (Milano) (IT); Ovonyx, Inc., 2956 Waterview Drive Rochester Hills, Michigan 48309 (US)
(72) Inventor: Casagrande, Giulio, 20060 Vignate (IT); Bez, Roberto, 20146 Milano (IT); Pellizzer, Fabio, 31051 Follina (IT)
(74) Representative: Cerbaro, Elena

(56) References cited:
- WO-A-02/09206
- US-A- 6 031 287
- US-A1- 2002 017 701

## Description

The present invention relates to a sublithographic contact structure, a phase change memory cell, and to a manufacturing process thereof.

As is known, phase change memory (PCM) elements exploit the characteristics of materials which have the property of changing between two phases having distinct electrical characteristics. For example, these materials may change from an amorphous phase, which is disorderly, to a crystalline or polycrystalline phase, which is orderly, and the two phases are associated to considerably different resistivity.

At present, alloys of group VI of the periodic table, such as Te or Se, referred to as chalcogenides or chalcogenic materials, can advantageously be used in phase change cells. The chalcogenide that currently offers the most promise is formed by a Ge, Sb and Te alloy (Ge₂Sb₂Te₅), which is currently widely used for storing information in overwritable disks.

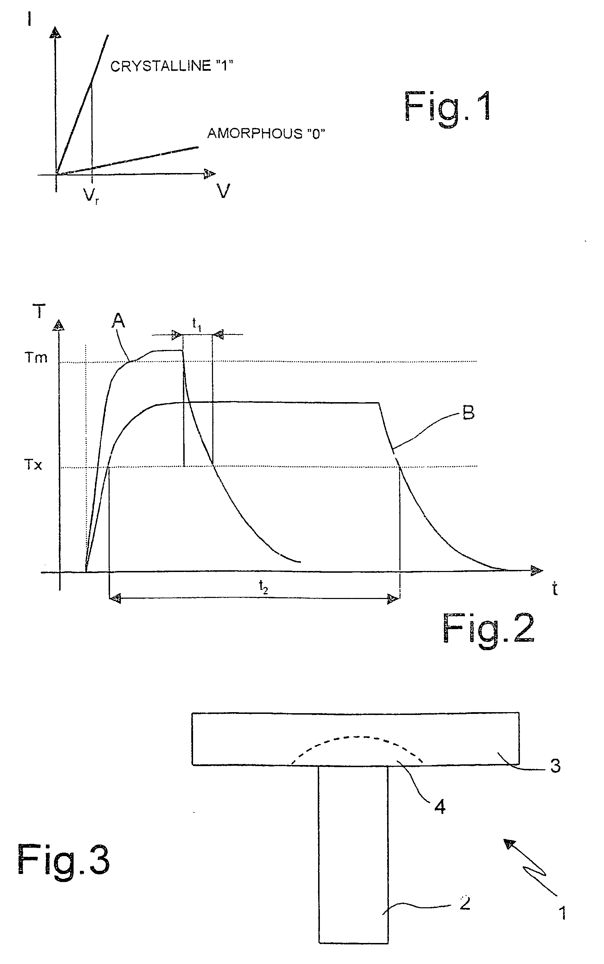

In chalcogenides, the resistivity varies by two or more magnitude orders when the material passes from the amorphous phase (more resistive) to the polycrystalline phase (more conductive) and vice versa. The characteristics of chalcogenides in the two phases are shown in Figure 1. As may be noted, at a given read voltage, here designated by Vr, there is a resistance variation of more than 10.

Phase change may be obtained by locally increasing the temperature, as shown in Figure 2. Below 150°C both phases are stable. Above 200°C (temperature of start of nucleation, designated by Tₓ), fast nucleation of the crystallites takes place, and, if the material is kept at the crystallization temperature for a sufficient length of time (time t₂), it changes its phase and becomes crystalline. To bring the chalcogenide back into the amorphous state, it is necessary to raise the temperature above the melting temperature Tₘ (approximately 600°C) and then to cool the chalcogenide off rapidly (time t₁).

From the electrical standpoint, it is possible to reach both critical temperatures, namely the crystallization temperature and the melting point, by causing a current to flow through a resistive element which heats the chalcogenic material by the Joule effect.

The basic structure of a PCM element 1 which operates according to the principles described above is shown in Figure 3 and comprises a resistive element 2 (heater) and a programmable element 3. The programmable element 3 is made of a chalcogenide and is normally in the polycrystalline state in order to enable a good flow of current. One part of the programmable element 3 is in direct contact with the resistive element 2 and forms the area affected by phase change, hereinafter referred to as the phase change portion 4.

If an electric current having an appropriate value is caused to pass through the resistive element 2, it is possible to heat the phase change portion 4 selectively up to the crystallization temperature or to the melting temperature and to cause phase change. In particular, if a current I flows through a resistive element 2 having resistance R, the heat generated is equal to I²R.

The use of the PCM element of Figure 3 for forming memory cells has already been proposed. In order to prevent noise caused by adjacent memory cells, the PCM element is generally associated to a selection element, such a MOS transistor, a bipolar transistor, or a diode.

All the known approaches are, however, disadvantageous due to the difficulty in finding solutions that meet present requirements as regards capacity for withstanding the operating currents and voltages, as well as functionality and compatibility with present CMOS technologies.

In particular, considerations of a technological and electrical nature impose the creation of a contact area of small dimensions, preferably 20 nm x 20 nm, between the chalcogenic region and a resistive element. However, these dimensions are much smaller than those that can be obtained with current optical (UV) lithographic techniques, which scarcely reach 100 linear nm.

To solve the above problem, patent application 01128461.9, filed on 5.12.2001, and entitled "Small area contact region, high efficiency phase change memory cell, and manufacturing method thereof", teaches forming the contact area as an intersection of two thin portions extending transversely with respect to one another and each of a sublithographic size. In order to form the thin portions, deposition of layers is adopted instead of a lithographic process, given that deposition makes it possible to obtain very thin layers, i.e., having a thickness much smaller than the current minimum size that can be achieved using lithographic techniques.

For a better understanding of the problem of the present invention, the manufacturing process object of the above mentioned patent application No. 01128461.9 will now be described.

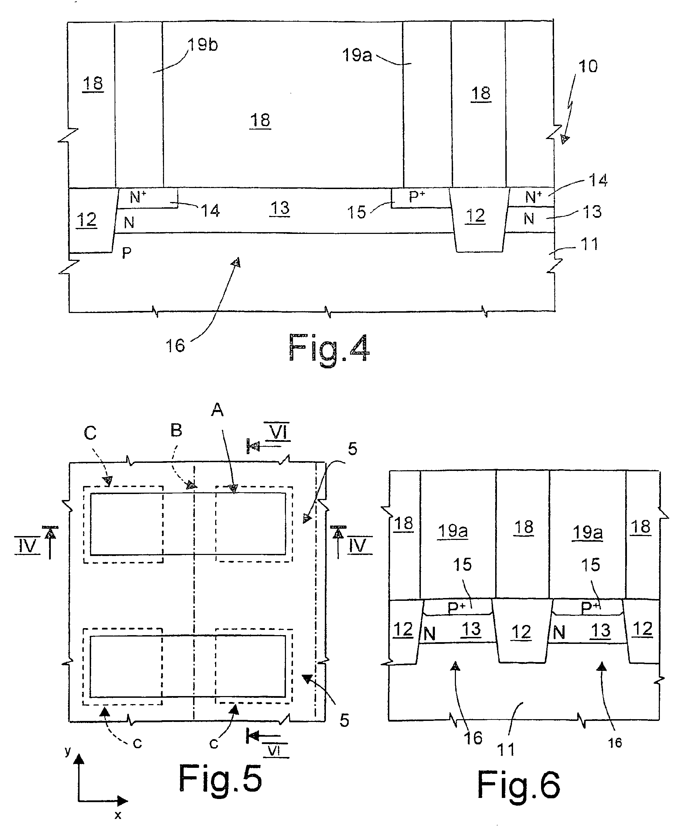

With reference to Figure 4, initially a wafer 10 comprising a P-type substrate 11 is subjected to standard front end steps. In particular, inside the substrate 11 insulation regions 12 are formed and delimit active areas 16; then, in succession, N-type base regions 13, N⁺-type base contact regions 14, and P⁺-type emitter regions 15 are implanted. The base regions 13, base contact regions 14, and emitter regions 15 form diodes that form selection elements for the memory cells.

Next, a first dielectric layer 18 is deposited and planarized; openings are formed in the first dielectric layer 18 above the base contact regions 13 and emitter regions 15, and the openings are filled with tungsten to form base contacts 19b and emitter contacts 19a. The base contacts 19b are thus in direct electrical contact with the base contact regions 13, and the emitter contacts 19a are in direct electrical contact with the emitter regions 15. Advantageously, the openings in the first dielectric layer 18 can be covered by a barrier layer, for example a Ti/TiN layer, before being filled with tungsten. In this way, the structure of Figure 4 is obtained.

Figure 5 shows the layout of some masks used for forming the structure of Figure 4 regarding a pair of memory cells 5 that are adjacent in a perpendicular direction to the sectional plane of Figure 4 (Y direction). In particular, the figure shows a mask A used for defining the active areas 16, a mask B used for implanting the emitter regions 15, and a mask C for forming the openings where the base contacts 19b and the emitter contacts 19a are to be formed. Figure 4 is a cross-section taken along line IV-IV of Figure 5, while Figure 6 shows the same structure sectioned along the section line VI-VI of Figure 5.

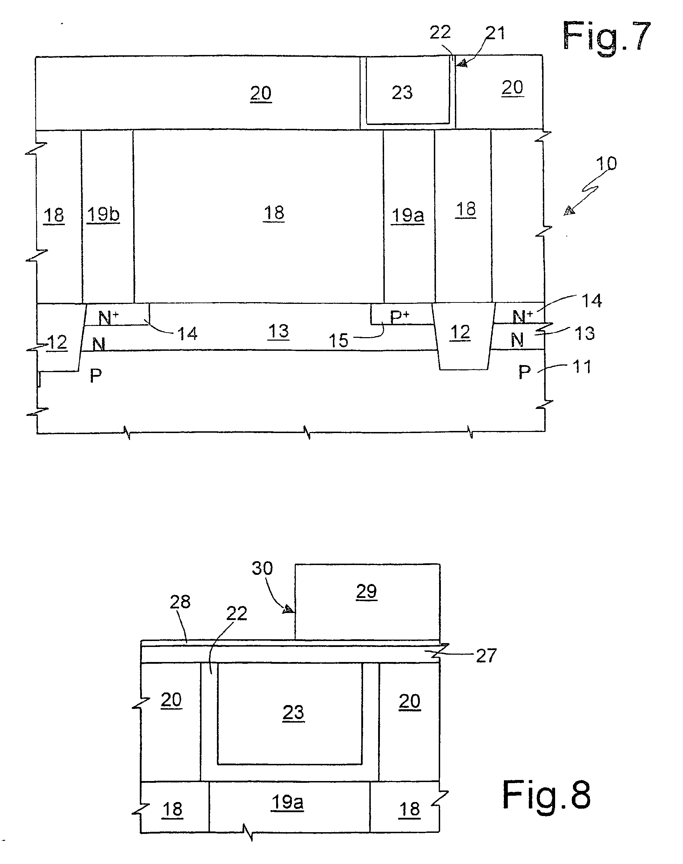

Next (Figure 7), a second dielectric layer 20 -for example, an undoped silicon glass (USG) layer- is deposited, and openings 21 are formed in the second dielectric layer 20 above the emitter contact 19a. The openings 21 have dimensions dictated by the lithographic process and are, for example, circle-shaped. Next, a heating layer, for example of TiSiN, TiAlN or TiSiC, is deposited for a thickness of 10-50 nm, preferably 20 nm. The heating layer, designed to form the resistive element 2 of Figure 3, conformally coats the walls and bottom of the openings 21 and is subsequently removed outside the openings 21. The remaining portions of the heating layer thus form a cup-shaped region 22 and are then filled with dielectric material 23.

Next, as shown in the enlarged detail of Figure 8, a mold layer 27, for instance USG having a thickness of 20 nm, an adhesion layer 28, for instance Ti or Si with a thickness of 5 nm, and a first delimiting layer 29, for example nitride or another material that enables selective etching with respect to the mold layer 27, are deposited in sequence. The first delimiting layer 29 has a thickness of, for instance, 150 nm. Then, using a mask, one part of the first delimiting layer 29 is removed by dry etching to form a step which has a vertical side 30 that extends vertically on top of the dielectric material 23. The structure shown in Figure 8 is thus obtained.

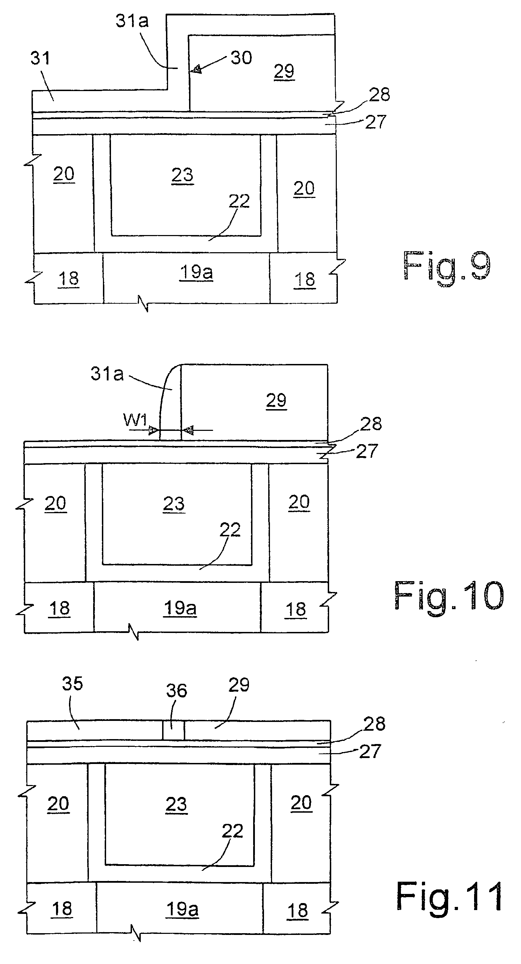

Next (Figure 9), a sacrificial layer 31, for example TiN with a thickness of 30 nm, is deposited conformally. In particular, the sacrificial layer forms a vertical wall 31a that extends along the vertical side 30 of the first delimiting layer 29.

Next (Figure 10), the sacrificial layer 31 is undergoes an etch back that results in removal of the horizontal portions of the sacrificial layer 31 and of part of the vertical wall 31a. By appropriately choosing the thickness of the first delimiting layer 29 and the thickness of the sacrificial layer 31, as well as the time and type of etching, it is possible to obtain the desired sublithographic width W1 for the bottom part of the remaining vertical wall 31a.

As shown in Figure 11, a second delimiting layer 35, of the same material as the first delimiting layer 29, for example nitride, with a thickness of 300 nm, is deposited. Next, the delimiting layers 29, 35 and the vertical wall 31a are thinned by chemical mechanical polishing (CMP). At the end, the remaining portions of the delimiting layers 29, 35 form a hard mask, and the remaining portion of the vertical wall forms a sacrificial region 36.

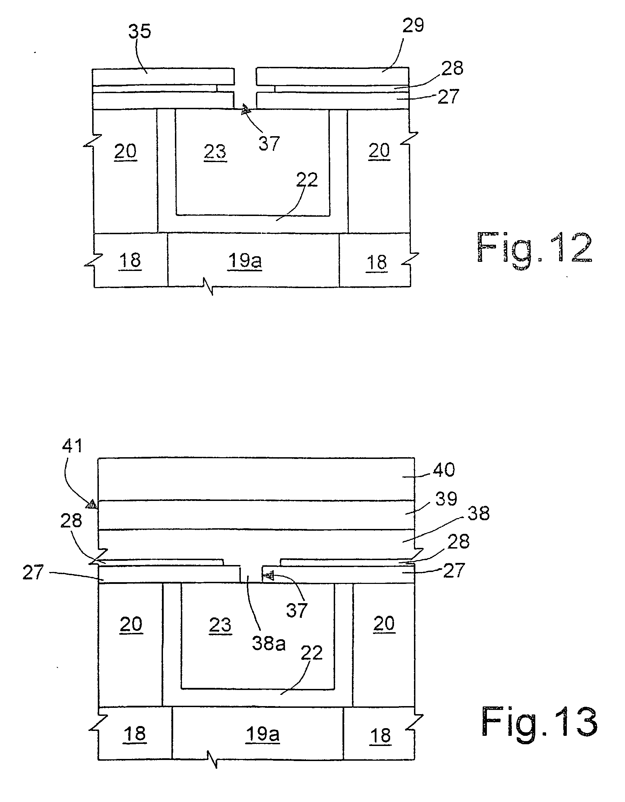

Next (Figure 12), the sacrificial region 36 is removed. The adhesion layer 28 is isotropically etched, and the mold layer 27 is dry etched to form a slit 37 in the mold layer 27, the slit 37 having a width W1 equal to the width of the sacrificial region 36.

Next (Figure 13), the delimiting layers 29, 35 are removed, and a chalcogenic layer 38, for example of Ge₂Sb₂Te₅ with a thickness of 60 nm, is deposited conformally. The portion 38a of the chalcogenic layer 38 fills the slit 37 and forms, at the intersection with the cup-shaped region 22, a phase change region similar to the phase change portion 4 of Figure 3. Then, on top of the chalcogenic layer 38 a barrier layer 39, for example of Ti/TiN, and a metal layer 40, for example of AlCu, are deposited. The structure of Figure 13 is thus obtained.

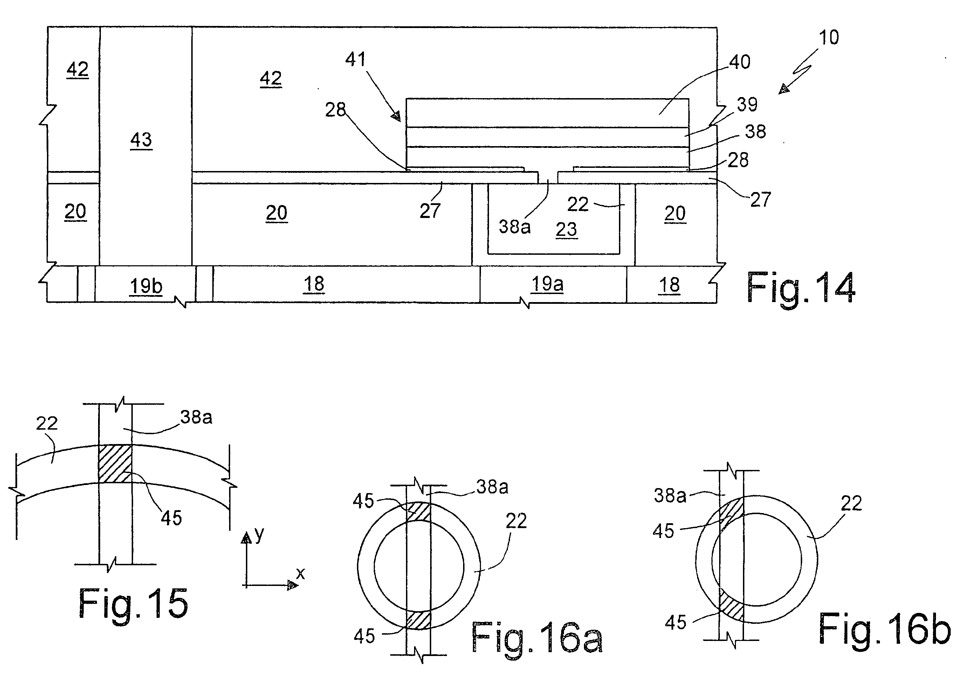

Next (Figure 14), the stack formed by the metal layer 40, the barrier layer 39 and the chalcogenic layer 38 is defined using a same mask, thus forming a bit line 41. Finally, a third dielectric layer 42 is deposited, which is opened above the base contacts 19b. The openings thus formed are filled with tungsten to form top contacts 43 in order to prolong upwards the base contacts 19b. Then standard steps are performed for forming the connection lines for connection to the base contacts 19b and to the bits lines 41, and the final structure of Figure 14 is thus obtained.

In practice, as shown in Figure 15, the intersection between the cup-shaped region 22 and the thin portion 38a of the chalcogenic layer 38 forms a contact area 45 which is approximately square and has sublithographic dimensions. This is due to the fact that both the cup-shaped region 22 and the thin portion 38a have a width equal to the thickness of a deposited layer. In fact, the width of the cup-shaped region 22 is given by the thickness of the heating layer, and the width of the thin portions 38a is determined by the thickness of the sacrificial layer 31 along the vertical side 30. In greater detail, in the proximity of the contact area 45, the cup-shaped region 22 has a sublithographic dimension in a first direction (Y direction), and the thin portion 38a has a sublithographic dimension (width W1 of Figure 10) in a second direction (X direction) which is transverse to the first direction. Hereinafter, the term "sublithographic dimension" means a linear dimension smaller than the limit dimension achievable with current optical (UV) lithographic techniques, and hence smaller than 100 nm, preferably 50-60 nm, down to approximately 20 nm.

In the process described above, forming the thin portion 38a of the chalcogenic layer 38 entails numerous steps and is somewhat complex. Consequently, it is desirable to avail a simpler alternative process.

In addition, the dimensions of the contact area 45 depend upon the alignment tolerances between the mask used for forming the openings 21 and the mask used for removing part of the first delimiting layer 29 and for forming the vertical side 30 (Figure 8). In fact, as emerges clearly from a comparison between Figures 16a and 16b which are top plan views of the contact area 45, in the case of a cup-like region 22 having a circular shape and a diameter of approximately 0.2 µm, an alignment error of even only 0.05 µm between the two masks results in the thin portions 38a no longer crossing the cup-shaped regions 22 perpendicularly, with a consequent considerable increase in the dimensions of the contact area 45 (see Figure 16b) and hence a considerable increase in the flowing current, the value whereof would be uncontrollable.

Furthermore, the thin portion 38a crosses each cup-shaped region 22 in two points, thus doubling the total contact area between the thin portions 38a and the cup-shaped regions 22, and consequently also increasing the programming current. In the case of a marked misalignment between the two above masks, just one contact area is even obtained which has dimensions far greater than the requirements. The presence of a double contact gives rise to functional problems, given that in this situation it would be impossible to know which of the two contact areas 45 first causes switching of the overlying thin portion 38a (i.e., the phase change portion), nor would it be possible to be certain that both of the thin portions 38a overlying the two contact areas will switch.

WO 02/09206 teaches an electrically programmable element including a cup-shaped cylindrical conductive sidewall spacer having raised portions. The raised portions have a thickness and a width having small dimensions obtained by deposition of the spacer material and by use of an etch mask obtained through the spacer technique. A layer of memory material extend on the raised portions and thus defines a small contact area therewith. The cylindrical conductive sidewall spacer may have different shapes, including a rectangular shape.

The aim of the present invention is to simplify and improve the process described in patent application 01128461.9, with particular regard to the problem of possible misalignments between the masks and of the consequent variability of the dimensions of the contact area.

According to the present invention there are provided a contact structure, a phase change memory cell, and a process for the manufacture thereof, as defined in Claims 1, 3, 11 and 13, respectively.

For a better understanding of the present invention, a preferred embodiment thereof is now described, purely by way of non-limiting example, with reference to the attached drawings, in which:
- Figure 1 shows the current versus voltage characteristic of a phase change material;
- Figure 2 shows the temperature versus current plot of a phase change material;
- Figure 3 shows the basic structure of a PCM memory element;
- Figure 4 shows a cross section of a wafer of semiconductor material in a manufacturing step of the cell of Figure 3, according to the aforementioned patent application;
- Figure 5 shows the layout of some masks used for forming the structure of Figure 4;
- Figure 6 is a cross-section taken along line VI-VI of Figure 5;
- Figures 7-14 are cross-section of the structure of the above mentioned patent application, in successive manufacture steps;
- Figure 15 is a top plan view, with parts removed and at an enlarged scale, of a detail of Figure 4;
- Figures 16a and 16b are top plan views, with parts removed, of a detail of Figure 14, in two different manufacture conditions;
- Figure 17 shows the layout of some masks used for forming the structure of Figure 7, according to the invention;
- Figure 18 is a cross-section similar to Figure 8, in a manufacture step according to the invention;
- Figure 19 shows the layout of some masks used for forming the structure of Figure 18;
- Figures 20 and 21 are cross-sections, similar to Figure 18, in successive manufacture steps according to the invention;
- Figure 22 is a top plan view of the structure of Figure 21;
- Figure 23 is a cross-section, similar to Figure 21, in a subsequent manufacture step;
- Figure 24 shows the layout of same masks used for forming the structure of Figure 23;
- Figure 25 is a cross-section, similar to Figure 14, in a final manufacture step according to the invention;
- Figures 26a and 26b are top plan views of the contact area, in two different manufacture conditions; and
- Figure 27 shows the layout of some masks used after forming the structure of Figure 10, according to a different embodiment of the invention; and
- Figure 28 shows the structure obtained using the masks of Figure 27.

In the following description, parts that are the same as those previously described with reference to Figures 4-14 are designated by the same reference numbers.

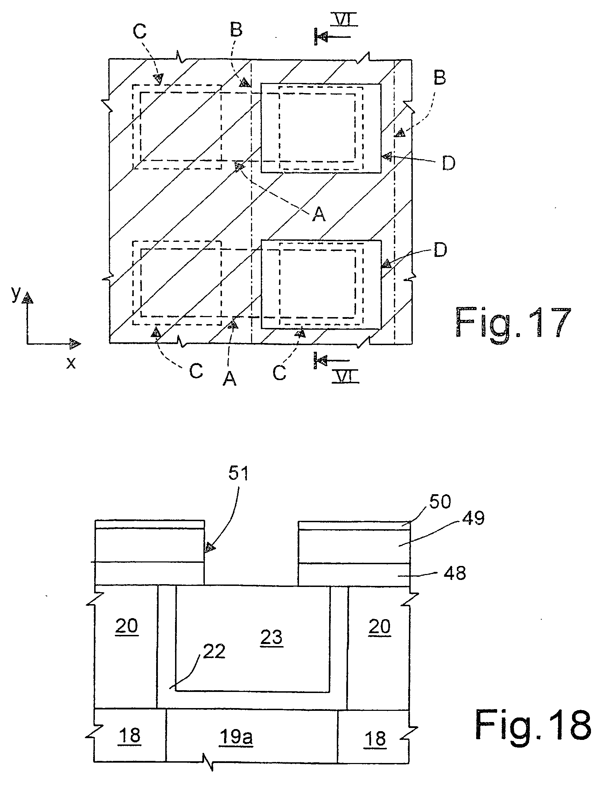

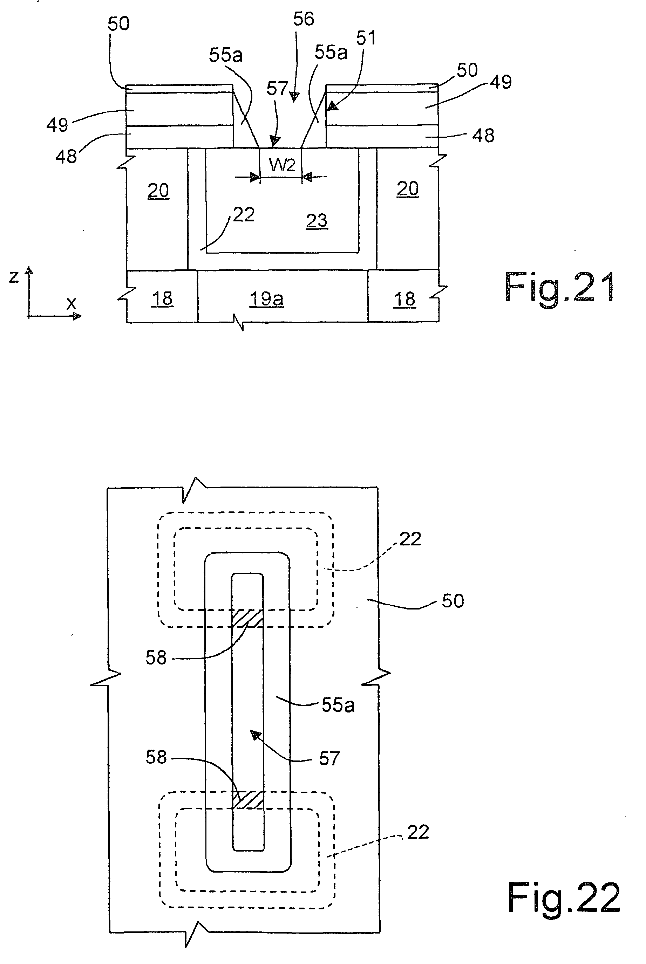

The process according to the present invention comprises initial steps equal to those described in patent application 01128461.9 illustrated above, up to deposition of the second dielectric layer 20 (Figure 7). Next, also here the openings 21 and the cup-shaped regions 22 are formed. However, as shown in Figure 17, for the definition of the openings 21, a heater mask D is used which has rectangular windows (the term "rectangular" also comprising the particular case of a square shape). Consequently, the openings 21 have a substantially rectangular shape. Then the heating layer, for example of TiSiN, TiAlN or TiSiC, with a thickness of 10-50 nm, preferably 20 nm, is deposited. The heating layer coats the walls and bottom of the openings 21 conformally. Consequently, in top plan view, the cup-like regions 22 here define an ideally rectangular shape, possibly with rounded edges (on account of the lithographic limits), or at the most an ovalized shape, with the longer side, or main direction, parallel to the X direction (Figure 22). Next, the heating layer is removed outside the openings 21 to form the cup-shaped regions 22, which are then filled with the dielectric material 23.

Then (Figure 18), a stop layer 48, for example of nitride deposited by PECVD (Plasma Enhanced Chemical Vapor Deposition) with a thickness of 20-40 nm, a mold layer 49, for example of USG deposited by PECVD or SACVD (Sub-Atmospheric Chemical Vapor Deposition) with a thickness of 70 nm, and an adhesion layer 50, for example of Ti or Si with a thickness of 20-40 nm, are deposited in sequence.

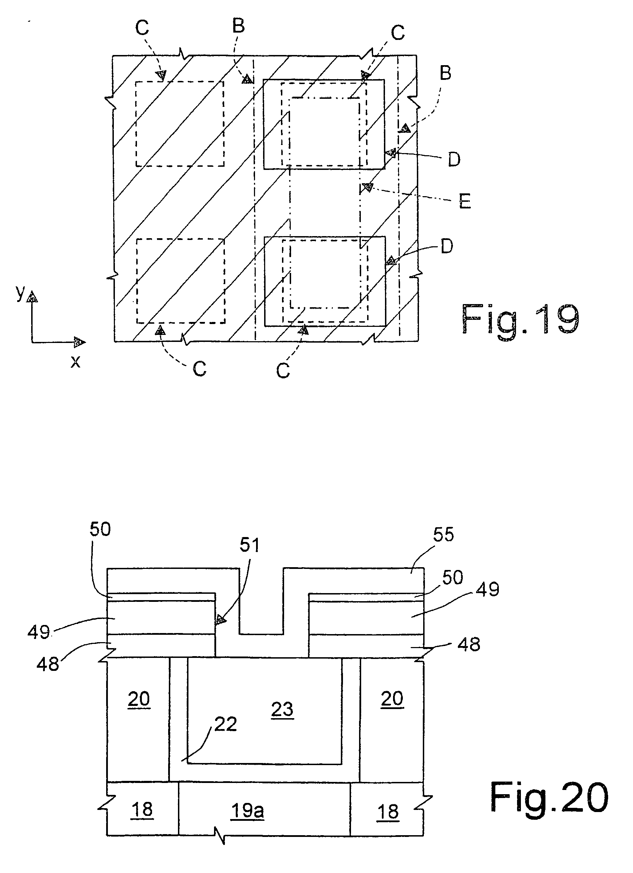

Next, using a minitrench mask, designated by E in Figure 19, the adhesion layer 50, the mold layer 49 and the stop layer 48 are etched. As shown in Figure 18, the minitrench mask E has a rectangular window that extends between two adjacent cells 5 in the Y direction (perpendicular to the alignment direction of the base and emitter regions 14, 15 of each memory cell 5, Figure 7).

Following upon etching, part of the layers 48, 49 and 50 is removed, so as to form an opening 51 having a rectangular shape, corresponding to that of the minitrench mask E. The width of the opening 51 in the X direction is, for example, 160 nm. The opening 51 uncovers part of the dielectric material 23 of the two adjacent cells 5 and crosses each cup-shaped region 22 only once, as can be clearly seen from the superposition of the heater mask D and minitrench mask E in Figure 19.

Next, Figure 20, a spacer layer 55, for example an oxide layer, is deposited (in particular, TEOS with a thickness of 50 nm). The spacer layer 55 covers the adhesion layer 50, as well as the walls and bottom of the opening 51.

Then, Figure 21, the spacer layer 55 is anisotropically etched by etching back until the horizontal portions thereof are removed, according to the well known spacer formation technique. The spacer layer 55 is then completely removed above the adhesion layer 50 and is partially removed from the bottom of the opening 51 to form a spacer region 55a which extends along the vertical sides of the opening 51 (along the perimeter of a rectangle or of an oval) and delimits a slit 56, the base whereof forms a rectangular strip 57 having a sublithographic width W2 (in the X direction) of approximately 60 nm. Figure 22 is a top plan view of the structure thus obtained, and highlights how the strip 57 uncovers only one portion of the cup-shaped region 22 of each cell 5, shown with dashed line in the figure. The uncovered portion of each cup-shaped region 22 forms a contact area 58, as will be explained hereinafter.

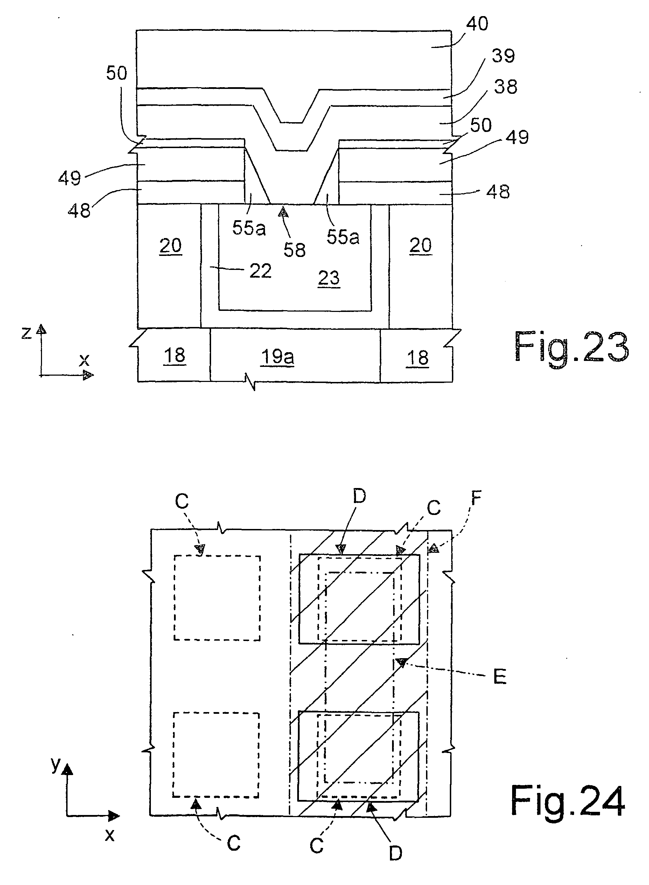

Next, Figure 23, the chalcogenic layer 38 (also in the present case, for instance, of Ge₂Sb₂Te₅ with a thickness of 60 nm), the barrier layer 39, and the metal layer 40 are deposited in succession, to form a stack of layers 41. The chalcogenic layer 38 is in direct contact with the adhesion layer 50, to which it adheres properly, and fills the slit 56 with a thin portion 38a. In particular, the thin portion 38a of the chalcogenic layer 38 deposits on the strip 57, contacting the cup-shaped regions 22 at the contact areas 58. The inclined wall formed by the spacer region 55a favors filling of the slit 56, so preventing problems linked to a poor aspect ratio of the opening 51.

Next, the stack of layers 41 is defined using a stack mask F (Figure 24).

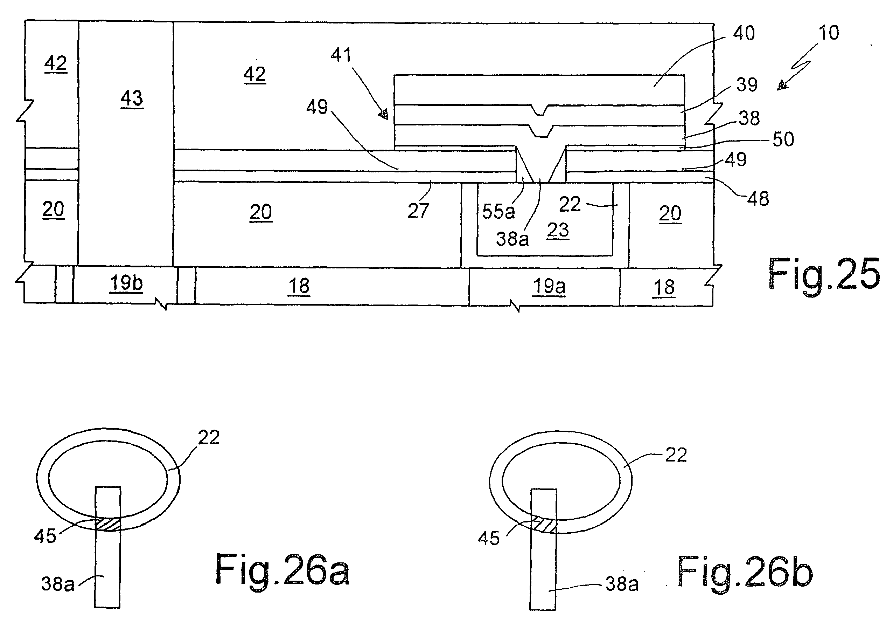

The process continues with the steps described previously, which comprise deposition of the third dielectric layer 42, opening of the third dielectric layer 42 above the base contacts 19b, formation of the top contacts 43, and formation of connection lines for connection to the base contacts 19b and to the bit lines 41, so as to obtain the final structure shown in Figure 25.

According to a different embodiment, the thin portion 38a of the chalcogenic layer 38 is formed using the technology described in the above patent application No. 01128461.9, and the second crossing-over of the cup-shaped region 22 by the thin portion 38a is avoided by using a special mask, called self-rapier mask, as described hereinafter.

In detail, the process comprises the same initial steps described with reference to Figures 4-9, with the sole difference that the cup-shaped region 22 is shaped using the heater mask D illustrated in Figure 17, so as to obtain a rectangular, or at the most oval, shape owing to the lithographic limits.

At this point in the fabrication process, the vertical wall 31a of the first delimitation layer 29 is present on the step 30, and the rest of the sacrificial layer has already been removed.

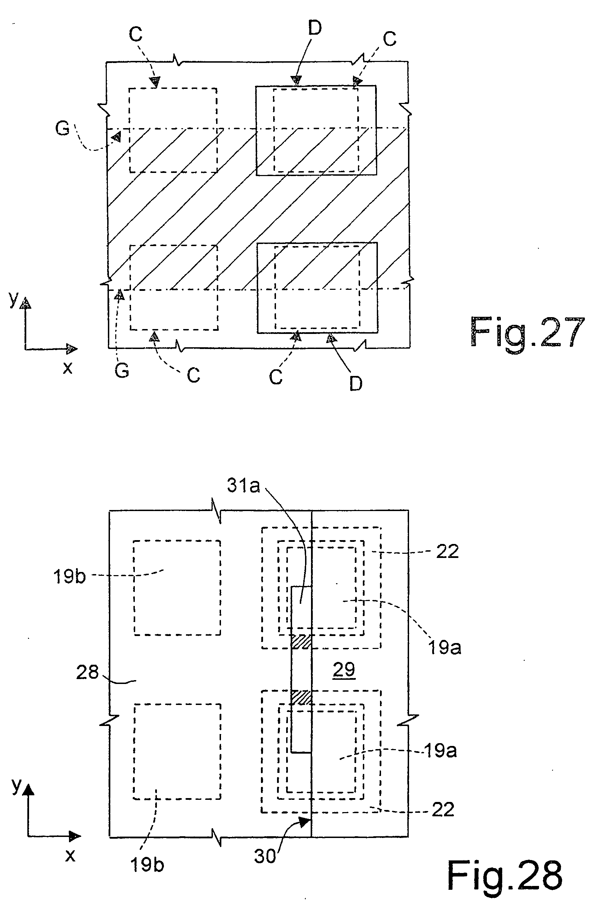

Next, using an appropriate mask, referred to as self-rapier mask G, illustrated in Figure 27, part of the vertical wall 31a is removed so that the latter will intersect the cup-shaped region 22 of each cell 5 only in one point. In detail, the self-rapier mask G covers a strip that bestrides two cells 5 in a direction parallel to the X direction. The portions of the vertical wall 31a not covered by the self-rapier mask G are then removed. In this way, as shown in the top plan view of Figure 28 of the two adjacent cells 5, just one portion of vertical wall 31a remains at the side of the step 30, the cross section whereof in the X-Z plane coincides with that of Figure 10 described above. As may be noted, the remaining portion of vertical wall 31a intersects each cup-shaped region 22 just once, as is highlighted by the hatched area which, later, forms the contact area 45.

The process proceeds with the same steps described above with reference to Figures 11-14, and then with deposition of the second delimitation layer 35; thinning-out of the delimitation layers 35 and 29, as well as of the vertical wall 31 until the structure illustrated in Figure 11 is obtained; removal of the sacrificial portion 36 and etching of the adhesion layers 28 and of the mold layer 27 (Figure 12); deposition of the chalcogenic layer 38 which fills the slit 37 of the mold layer 27; deposition of the barrier layer 39 and of the metal layer 40; shaping of the stack formed by the metal layer 40, the barrier layer 39 and the chalcogenic layer 38; deposition of the third dielectric layer 42; and the final steps described above for obtaining the structure illustrated in Figure 14.

In practice, in both of the embodiments, thin portions 38a are formed, that have a roughly parallelepipedal shape and short length, i.e., smaller than the overall dimensions of two cells 5 in the Y direction. In the first embodiment, the thin portion 38a is delimited by the spacer region 55a; in the second embodiment, the thin portion 38a is delimited directly by the mold layer 27.

The advantages of the process and structure described herein are illustrated hereinafter. First place, the rectangular or ovalized shape of the cup-shaped region 22 reduces the dimension spread of the contact area 58 also when its shape, instead of being rectangular, as in the ideal case, is oval, as highlighted by the comparison between Figure 26a, showing the relative position of the cup-shaped region 22 and the thin region 38a in absence of mask misalignment, and Figure 26b, which illustrates this position in presence of misalignment. In particular, as may be seen in the case of a cup-shaped region 22 having an ovalized shape, misalignments between the heater mask D and the minitrench mask E or the mask defining the first delimitation layer 29 lead to a negligible variation in the contact area. In the ideal case in which the cup-shaped region 22 has a rectangular shape, the variation in dimensions is even zero.

In the embodiment illustrated in Figures 17-25, the sequence of steps required for forming the thin portion 38a is simplified, and the chalcogenic layer 38 adheres perfectly to the underlying layers and fills the opening 51 correctly, thanks to the inclination of the spacer region 55a, as already mentioned previously.

Furthermore, the shape of the minitrench mask E or the use of the self-rapier mask G makes it possible to obtain a single contact area 58 for each cup-shaped region 22, and thus for each cell 5.

Finally, it is clear that numerous modifications and variations may be made to the process and to the memory cell described and illustrated herein, all falling within the scope of the invention, as defined in the attached claims. In particular, although the invention has been illustrated with particular reference to a phase change memory cell, it is applicable to any sublithographic contact area between two regions each having just one sublithographic dimension, affected by the same problem of dimension variability, for example on account of the misalignment of the corresponding masks.

## Claims

1. A contact structure in a semiconductor electronic device, comprising:
a first cup-shaped conductive region (22) comprising vertical walls that form a first thin portion having a first sublithographic dimension in a first direction (y) ;
a second conductive region (38) comprising a second thin portion (38a) having a second sublithographic dimension in a second direction (X) transverse to said first dimension, said first and second conductive regions being in direct electrical contact at said first and second thin portions and defining a contact area having a sublithographic extension,
in which said first conductive region (22) extends, in top plan view, along a closed line having an elongated shape in said second direction (x).

2. The contact structure according to Claim 1, wherein said elongated shape is chosen between rectangular and elongated oval.

3. A phase change memory cell (5) comprising:
a cup-shaped resistive element (22) comprising vertical walls forming a first sublithographic portion in a first direction (Y); and
a memory region (38) of a phase change material including a second thin portion (38a) having a second sublithographic dimension in a second direction (X) transverse to said first dimension;
said resistive element (22) and said memory region (38) being in direct electrical contact at said first thin portion (22) and said second thin portion (38a) and defining a contact area (58) having a sublithographic extension,
wherein said resistive element (22) extends, in top plan view, along a closed line having an elongated shape in said second direction (x).

4. The memory cell according to Claim 3, wherein said elongated shape is chosen between rectangular and elongated oval.

5. The memory cell according to Claim 3 or 4, wherein said memory region (38) crosses, and is in direct electrical contact with, said resistive element (22) only at said first thin portion (22) so as to form a single contact area (45, 58) .

6. The memory cell according to any one of Claims 3 to 5, wherein said second thin portion (38a) is laterally delimited, at least in said second direction, by spacer portions (55a) of a first dielectric material defining surfaces that are inclined in a third direction transverse to said first and second directions.

7. The memory cell according to Claim 6, wherein said spacer portions (55a) are surrounded by a mold layer (49) of a second dielectric material forming a lithographic opening.

8. The memory cell according to any one of Claims 3 to 5, wherein said second thin portion (38a) is surrounded by a mold layer (27, 49) of a second dielectric material forming an opening (37; 51) having an approximately rectangular shape.

9. The memory cell according to Claim 8, wherein said second thin portion (38a) is in direct contact with said mold layer (27) and said opening (37) is of a sublithographic dimension.

10. The memory cell according to any one of Claims 3 to 9, wherein said second thin portion (38a) has a substantially elongated shape with a principal dimension extending parallel to said first direction (Y).

11. A process for manufacturing a semiconductor electronic device having a contact area, comprising:
forming a first cup-shaped conductive region (22) comprising vertical walls forming a first thin portion having a first sublithographic, dimension in a first direction (y);
forming a second conductive region (38) comprising a second thin portion (38a) having a second sublithographic dimension in a second direction (X) transverse to said first dimension, said first and second conductive regions being in direct electrical contact at said first and second thin portions and defining a contact area having a sublithographic extension,
wherein said first conductive region (22) extends, in top plan view, along a closed line of elongated shape in said second direction (x).

12. The process according to Claim 11, wherein said elongated shape is chosen between rectangular and elongated oval.

13. A process for manufacturing a phase change memory cell, comprising:
forming a cup-shaped resistive element (22) comprising vertical walls forming a first thin portion having a first sublithographic dimension in a first direction (Y); and
forming a memory region (38) of a phase change material in direct electrical contact with said first thin portion including a second thin portion (38a) and having a second sublithographic dimension in a second direction (X) transverse to said first dimension;
said first and second thin portions (22, 38a) defining a contact area (58) having a sublithographic extension,
wherein said resistive element (22) extends, in top plan view, along a closed line having an elongated shape in said second directions (x).

14. The process according to Claim 13, wherein said elongated shape is chosen between rectangular and elongated oval.

15. The process according to Claim 13 or Claim 14, wherein said step of forming a resistive element (22) comprises forming a first lithographic opening (21) in an insulating layer (20), depositing a conductive layer (22) on a side wall of said second lithographic opening, and filling (23) said second lithographic opening.

16. The process according to any one of Claims 13 to 15, wherein said step of forming a memory region (38) comprises forming a mold structure (27; 49, 55a) on top of said resistive element, said mold structure having a slit (56) crossing said fist thin portion (22) only in one point, said slit having said second sublithographic dimension; depositing a phase change layer (38) at least inside said slit and forming said second thin portion (38a).

17. The process according to Claim 16, wherein said step of forming a mold structure (49, 55a) comprises depositing a mold layer (49); forming a second lithographic opening (51) in said mold layer; and forming spacer portions (55a) in said second lithographic opening, said spacer portions delimiting said slit.

18. The process according to Claim 17, wherein said step of forming spacer portions (55a) comprises, after said step of forming a second lithographic opening (51), depositing a spacer layer (55) and anisotropically etching said spacer layer.

19. The process according to Claim 16, wherein said resistive layer (22) is formed in an insulating layer (20) and said step of forming a mold structure (27) comprises depositing a first delimitation layer (29) on top of said insulating layer, said first delimitation layer (29) forming a step having a vertical wall (30) extending transversely tc said first thin portion (22); forming a sacrificial portion (31a) along said vertical wall; removing part of said sacrificial portion to form a sacrificial region (31a) that crosses said resistive element (22) in just one point; forming a second delimitation area (35) extending above said insulating layer (20) and at the sides of said sacrificial region (31a) as well as of said first delimitation layer (29); and removing said sacrificial region to form a delimitation opening (37).

20. The process according to Claim 19, wherein, before forming a first delimitation layer (29), the step is carried out of depositing a mold layer (27) on top of said insulating layer (20); and in which, after said step of removing said sacrificial region (31a), the steps are carried out of forming said slit (37) in said mold layer underneath said delimitation opening and removing said first delimitation layer (29) and said second delimitation layer (35).

## Patentansprüche

1. Kontaktstruktur bei einer elektronischen Halbleitervorrichtung, aufweisend:
einen ersten becherförmigen leitfähigen Bereich (22) mit vertikalen Wänden, die einen ersten dünnen Bereich mit einer ersten sublithografischen Dimension in einer ersten Richtung (Y) bilden;
einen zweiten leitfähigen Bereich (38) mit einem zweiten dünnen Bereich (38a), der eine zweite sublithografische Dimension in einer zweiten Richtung (X) quer zu der ersten Richtung aufweist, wobei der erste und der zweite leitfähige Bereich an dem ersten und dem zweiten dünnen Bereich in direktem elektrischen Kontakt stehen und einen Kontaktbereich mit sublithografischer Erstreckung bilden,
wobei sich der erste leitfähige Bereich (22), in der Draufsicht betrachtet, entlang einer geschlossenen Linie erstreckt, die in der zweiten Richtung (X) eine längliche Formgebung aufweist.

2. Kontaktstruktur nach Anspruch 1,
wobei die längliche Formgebung zwischen rechteckig und länglich oval gewählt ist.

3. Phasenänderungs-Speicherzelle (5), aufweisend:
ein becherförmiges Widerstandselement (22) mit vertikalen Wänden, die einen ersten sublithografischen Bereich in einer ersten Richtung (Y) bilden; und
einen Speicherbereich (38) aus einem Phasenänderungsmaterial, der einen zweiten dünnen Bereich (38a) aufweist, der eine zweite sublithografische Dimension in einer zweiten Richtung (X) quer zu der ersten Richtung aufweist;
wobei das Widerstandselement (22) und der Speicherbereich (38) an dem ersten dünnen Bereich (22) und dem zweiten dünnen Bereich (38a) in direktem Kontakt stehen und einen Kontaktbereich (58) mit sublithografischer Erstreckung bilden,
wobei sich das Widerstandselement (22), in der Draufsicht betrachtet, entlang einer geschlossenen Linie erstreckt, die in der zweiten Richtung (X) eine längliche Formgebung aufweist.

4. Speicherzelle nach Anspruch 3,
wobei die längliche Formgebung zwischen rechteckig und länglich oval gewählt ist.

5. Speicherzelle nach Anspruch 3 oder 4,
wobei der Speicherbereich (38) das Widerstandselement (22) nur an dem ersten dünnen Bereich (22) kreuzt und mit diesem in direktem elektrischen Kontakt steht, so dass ein einziger Kontaktbereich (45, 58) gebildet ist.

6. Speicherzelle nach einem der Ansprüche 3 bis 5,
wobei der zweite dünne Bereich (38a) zumindest in der zweiten Richtung durch Abstandsbereiche (66a) aus einem ersten dielektrischen Material seitlich begrenzt ist, die Oberflächen bilden, die in einer zu der ersten und der zweiten Richtung quer verlaufenden dritten Richtung geneigt sind.

7. Speicherzelle nach Anspruch 6,
wobei die Abstandsbereiche (55a) von einer Formschicht (49) aus einem zweiten dielektrischen Material umgeben sind, die eine lithografische Öffnung bildet.

8. Speicherzelle nach einem der Ansprüche 3 bis 5,
wobei der zweite dünne Bereich (38a) von einer Formschicht (27, 49) aus einem zweiten dielektrischen Material umgeben ist, die eine Öffnung (37; 51) mit einer in etwa rechteckigen Formgebung aufweist.

9. Speicherzelle nach Anspruch 8,
wobei der zweite dünne Bereich (38a) in direktem Kontakt mit der Formschicht (27) steht und die Öffnung (37) eine sublithografische Dimension aufweist.

10. Speicherzelle nach einem der Ansprüche 3 bis 9,
wobei der zweite dünne Bereich (38a) eine im Wesentlichen längliche Formgebung mit einer Hauptdimension aufweist, die parallel zu der ersten Richtung (Y) verläuft.

11. Verfahren zum Herstellen einer elektronischen Halbleitervorrichtung mit einem Kontaktbereich, das folgende Schritte aufweist:
Bilden eines ersten becherförmigen leitfähigen Bereichs (22) mit vertikalen Wänden, die einen ersten dünnen Bereich mit einer ersten sublithografischen Dimension in einer ersten Richtung (Y) bilden;
Bilden eines zweiten leitfähigen Bereichs (38) mit einem zweiten dünnen Bereich (38a), der eine zweite sublithografische Dimension in einer zweiten Richtung (X) quer zu der ersten Richtung aufweist, wobei der erste und der zweite leitfähige Bereich an dem ersten und dem zweiten dünnen Bereich in direktem elektrischen Kontakt stehen und einen Kontaktbereich mit sublithografischer Erstreckung bilden,
wobei sich der erste leitfähige Bereich (22), in der Draufsicht betrachtet, entlang einer geschlossenen Linie erstreckt, die in der zweiten Richtung (X) eine längliche Formgebung aufweist.

12. Verfahren nach Anspruch 11,
wobei die längliche Formgebung zwischen rechteckig und länglich oval gewählt wird.

13. Verfahren zum Herstellen einer Phasenänderungs-Speicherzelle,
das folgende Schritte aufweist:
Bilden eines becherförmigen Widerstandselements (22) mit vertikalen Wänden, die einen ersten dünnen Bereich mit einer ersten sublithografischen Dimension in einer ersten Richtung (Y) bilden; und
Bilden eines Speicherbereichs (38) aus einem Phasenänderungsmaterial in direktem elektrischen Kontakt mit dem ersten dünnen Bereich, wobei der Speicherbereich (38) einen zweiten dünnen Bereich (38a) beinhaltet und eine zweite sublithografische Dimension in einer zweiten Richtung (X) quer zu der ersten Richtung aufweist;
wobei der erste und der zweite dünne Bereich (22, 38) einen Kontaktbereich (58) mit sublithografischer Erstreckung bilden,
wobei sich das Widerstandselement (22), in der Draufsicht betrachtet, entlang einer geschlossenen Linie erstreckt, die in der zweiten Richtung (X) eine längliche Formgebung aufweist.

14. Verfahren nach Anspruch 13,
wobei die längliche Formgebung zwischen rechteckig und länglich oval gewählt wird.

15. Verfahren nach Anspruch 13 oder Anspruch 14,
wobei der Schritt zum Bilden eines Widerstandselement (22) das Bilden einer ersten lithografischen Öffnung (21) in einer Isolierschicht (20), das Aufbringen einer leitfähigen Schicht (22) an einer Seitenwand der zweiten lithografischen Öffnung sowie das Füllen (23) der zweiten lithografischen Öffnung aufweist.

16. Verfahren nach einem der Ansprüche 13 bis 15,
wobei der Schritt zum Bilden eines Speicherbereichs (38) Folgendes aufweist:
Bilden eines Formgebungsgebildes (27; 49a, 55a) oben auf dem Widerstandselement, wobei das Formgebungsgebilde einen Schlitz (56) aufweist, der den ersten dünnen Bereich (22) nur an einer Stelle kreuzt und
wobei der Schlitz die zweite sublithografische Dimension aufweist;
Aufbringen einer Phasenänderungsschicht (38) zumindest innerhalb des Schlitzes und Bilden des zweiten dünnen Bereichs (38a).

17. Verfahren nach Anspruch 16,
wobei der Schritt zum Bilden eines Formgebungsgebildes (49a, 55a) Folgendes aufweist:
Aufbringen einer Formschicht (49);
Bilden einer zweiten lithografischen Öffnung (51) in der Formschicht; und
Bilden von Abstandsbereichen (55a) in der zweiten lithografischen Öffnung, wobei die Abstandsbereiche den Schlitz abgrenzen.

18. Verfahren nach Anspruch 17,
wobei bei dem Schritt zum Bilden von Abstandsbereichen (55a) nach dem Schritt zum Bilden einer zweiten lithografischen Öffnung (51) eine Abstandsschicht (55) aufgebracht wird und die Abstandsschicht anisotrop geätzt wird.

19. Verfahren nach Anspruch 16,
wobei die Widerstandsschicht (22) in einer Isolierschicht (20) gebildet wird und der Schritt zum Bilden eines Formgebungebildes (27) Folgendes aufweist:
Aufbringen einer ersten Abgrenzungsschicht (29) oben auf der Isolierschicht, wobei die erste Abgrenzungsschicht (29) eine Stufe bildet, die eine vertikale Wand (30) aufweist, die sich quer zu dem ersten dünnen Bereich (22) erstreckt;
Bilden eines Opferbereichs (31a) entlang der vertikalen Wand;
Entfernen eines Teils des Opferbereichs zum Bilden einer Opferregion (31a), die das Widerstandselement (22) an nur einer Stelle kreuzt;
Bilden eines zweiten Abgrenzungsbereichs (35), der sich über der Isolierschicht (20) und an den Seiten des Opferbereichs (31a) sowie auch der ersten Abgrenzungsschicht (29) erstreckt; und
Entfernen der Opferregion zum Bilden einer Abgrenzungsöffnung (37).

20. Verfahren nach Anspruch 19,
wobei vor dem Bilden einer ersten Abgrenzungsschicht (29) der Schritt erfolgt, in dem eine Formschicht (37) oben auf der Isolierschicht (20) aufgebracht wird; und wobei nach dem Schritt des Entfernens der Opferregion (31a), die Schritte erfolgen, in denen der Schlitz (37) in der Formschicht unter der Abgrenzungsöffnung gebildet wird und die erste Abgrenzungsschicht (29) und die zweite Abgrenzungsschicht (35) entfernt werden.

## Revendications

1. Structure de contact dans un dispositif électronique semi-conducteur comprenant :
une première région conductrice en forme de coupelle (22) comprenant des parois verticales qui forment une première partie fine ayant une première dimension sub-lithographique dans une première direction (Y) ;
une seconde région conductrice (38) comprenant une seconde partie fine (38a) ayant une seconde dimension sub-lithographique dans une deuxième direction (X) transversale par rapport à ladite première dimension, lesdites première et seconde régions conductrices étant en contact électrique direct au niveau desdites première et seconde parties fines et définissant une zone de contact ayant une extension sub-lithographique,
dans laquelle ladite première région conductrice (22) s'étend, en vue en plan de dessus, le long d'une ligne fermée ayant une forme allongée dans ladite deuxième direction (X).

2. Structure de contact selon la revendication 1, dans laquelle ladite forme allongée est choisie entre rectangulaire et ovale allongée.

3. Cellule mémoire à changement de phase (5) comprenant :
un élément résistif en forme de coupelle (22) comprenant des parois verticales formant une première partie sub-lithographique dans une première direction (Y) ; et
une région mémoire (38) d'un matériau à changement de phase incluant une seconde partie fine (38a) ayant une seconde dimension sub-lithographique dans une deuxième direction (X) transversale par rapport à ladite première dimension ;
ledit élément résistif (22) et ladite région mémoire (38) étant en contact électrique direct au niveau de ladite première partie fine (22) et de ladite seconde partie fine (38a) et définissant une zone de contact (58) ayant un prolongement sub-lithographique,
dans laquelle ledit élément résistif (22) s'étend, en vue en plan de dessus, le long d'une ligne fermée ayant une forme allongée dans ladite deuxième direction (X).

4. Cellule mémoire selon la revendication 3, dans laquelle ladite forme allongée est choisie entre rectangulaire et ovale allongée.

5. Cellule mémoire selon la revendication 3 ou 4, dans laquelle ladite région mémoire (38) traverse, et est en contact électrique direct avec, ledit élément résistif (22) uniquement au niveau de ladite première partie fine (22) de manière à former une zone de contact unique (45, 58).

6. Cellule mémoire selon l'une quelconque des revendications 3 à 5, dans laquelle ladite seconde partie fine (38a) est délimitée latéralement, au moins dans ladite deuxième direction, par des parties d'espacement (55a) d'un premier matériau diélectrique définissant des surfaces qui sont inclinées dans une troisième direction transversale par rapport auxdites première et deuxième directions.

7. Cellule mémoire selon la revendication 6, dans laquelle lesdites parties d'espacement (55a) sont entourées par une couche moulée (49) d'un second matériau diélectrique formant une ouverture lithographique.

8. Cellule mémoire selon l'une quelconque des revendications 3 à 5, dans laquelle ladite seconde partie fine (38a) est entourée par une couche moulée (27, 49) d'un second matériau diélectrique formant une ouverture (37 ; 51) ayant une forme approximativement rectangulaire.

9. Cellule mémoire selon la revendication 8, dans laquelle ladite seconde partie fine (38a) est en contact direct avec ladite couche moulée (27) et ladite ouverture (37) est d'une dimension sub-lithographique.

10. Cellule mémoire selon l'une quelconque des revendications 3 à 9, dans laquelle ladite seconde partie fine (38a) a une forme sensiblement allongée avec une dimension principale s'étendant parallèlement à ladite première direction (Y).

11. Procédé de fabrication d'un dispositif électronique semi-conducteur ayant une surface de contact, comprenant :
la formation d'une première région conductrice en forme de coupelle (22) comprenant des parois verticales formant une première partie fine ayant une première dimension sub-lithographique dans une première direction (Y) ;
la formation d'une seconde région conductrice (38) comprenant une seconde partie fine (38a) ayant une seconde dimension sub-lithographique dans une deuxième direction (X) transversale par rapport à ladite première dimension, lesdites première et seconde régions conductrices étant en contact électrique direct au niveau desdites première et seconde parties fines et définissant une zone de contact ayant une extension sub-lithographique,
dans lequel ladite première région conductrice (22) s'étend, en vue en plan de dessus, le long d'une ligne fermée de forme allongée dans ladite deuxième direction (X).

12. Procédé selon la revendication 11, dans lequel ladite forme allongée est choisie entre rectangulaire et ovale allongée.

13. Procédé de fabrication d'une cellule mémoire à changement de phase, comprenant :
la formation d*'*un élément résistif en forme de coupelle (22) comprenant des parois verticales formant une première partie fine ayant une première dimension sub-lithographique dans une première direction (Y) ; et
la formation d'une région mémoire (38) d'un matériau à changement de phase en contact électrique direct avec ladite première partie fine comprenant une seconde partie fine (38a) et ayant une seconde dimension sub-lithographique dans une deuxième direction (X) transversale par rapport à ladite première dimension ;
lesdites première et seconde parties fines (22, 38a) définissant une zone de contact (58) ayant une extension sub-lithographique,
dans lequel ledit élément résistif (22) s'étend, en vue en plan de dessus, le long d'une ligne fermée ayant une forme allongée dans ladite deuxième direction (X).

14. Procédé selon la revendication 13, dans lequel ladite forme allongée est choisie entre rectangulaire et ovale allongée.

15. Procédé selon la revendication 13 ou la revendication 14, dans lequel ladite étape de formation d'un élément résistif (22) comprend la formation d'une première ouverture lithographique (21) dans une couche isolante (20), le dépôt d'une couche conductrice (22) sur une paroi latérale de ladite seconde ouverture lithographique, et le remplissage (23) de ladite seconde ouverture lithographique.

16. Procédé selon l'une quelconque des revendications 13 à 15, dans lequel ladite étape de formation d'une région mémoire (38) comprend la formation d'une structure moulée (27 ; 49, 55a) au-dessus dudit élément résistif, ladite structure moulée ayant une fente (56) traversant ladite première partie fine (22) uniquement en un point, ladite fente ayant ladite seconde dimension sub-lithographique ;
le dépôt d'une couche à changement de phase (38) au moins à l'intérieur de ladite fente et la formation de ladite seconde partie fine (38a).

17. Procédé selon la revendication 16, dans lequel ladite étape de formation d'une structure moulée (49, 55a) comprend le dépôt d'une couche moulée (49) ; la formation d'une seconde ouverture lithographique (51) dans ladite couche moulée ; et la formation de parties d'espacement (55a) dans ladite seconde ouverture lithographique, lesdites parties d'espacement délimitant ladite fente.

18. Procédé selon la revendication 17, dans lequel ladite étape de formation des parties d'espacement (55a) comprend, après ladite étape de formation d'une seconde ouverture lithographique (51), le dépôt d'une couche d'espacement (55) et la gravure anisotrope de ladite couche d'espacement.

19. Procédé selon la revendication 16, dans lequel ladite couche résistive (22) est formée dans une couche isolante (20) et ladite étape de formation d'une structure moulée (27) comprend les étapes de dépôt d'une première couche de délimitation (29) au-dessus de ladite couche isolante, ladite première couche de délimitation (29) formant une marche ayant une paroi verticale (30) s'étendant de manière transversale par rapport à ladite première partie fine (22) ; de formation d'une partie sacrificielle (31a) le long de ladite paroi verticale ; de retrait d'une partie de ladite partie sacrificielle pour former une région sacrificielle (31a) qui traverse ledit élément résistif (22) en un point uniquement ; de formation d'une seconde zone de délimitation (35) s'étendant au-dessus de ladite couche isolante (20) et au niveau des côtés de ladite région sacrificielle (31a) ainsi que de ladite première couche de délimitation (29) ; et de retrait de ladite région sacrificielle pour former une ouverture de délimitation (37).

20. Procédé selon la revendication 19, dans lequel, avant la formation d'une première couche de délimitation (29), une étape de dépôt d'une couche moulée (27) au-dessus de ladite couche isolante (20) est réalisée ; et dans lequel, après ladite étape de retrait de ladite région sacrificielle (31a), des étapes de retrait de ladite fente (37) dans ladite couche moulée au-dessous de ladite ouverture de délimitation et de retrait de ladite première couche de délimitation (29) et ladite seconde couche de délimitation (35) sont réalisées.
